# EUROPEAN PATENT SPECIFICATION

(11) **EP 2 051 303 B1**
(45) Date of publication and mention of the grant of the patent: **05.07.2017**
(21) Application number: 08013302.8
(22) Date of filing: 24.07.2008
(51) Int. Cl.: H01L 31/0203, H01L 31/0352, A61B 5/00

(54) **Method to detect poor infrared rays, Microchip that is able to detect poor infrared rays and apparatus working with these microchips**
Verfahren zur Erkennung schwacher Infrarotstrahlen, zur Erkennung von schwachen Infrarotstrahlen fähiger Mikrochip und Vorrichtung mit diesen Mikrochips
Procédé pour détecter les faibles rayons infrarouges, micro-puce qui est capable de détecter les faibles rayons infrarouges et appareil fonctionnant avec ces micro-puces

(30) Priority: 28.08.2007 US 895800
(43) Date of publication of application: 22.04.2009
(73) Proprietor: Biomimetics Technologies Inc., Toronto, ON M6S 2X4 (CA)
(72) Inventor: Gille, Christoph, 16540 Hohen Neuendorf (DE); Holmes, Chris, 42105 Wuppertal (DE); Israelowitz, Meir, Toronto, Ontario M4K 2X4 (CA); Rizvi, Syed W. H., Toronto, Ontario M6S 2X4 (CA); P.Von Schroeder, Herbert, Toronto, Ontario M6S 2X4 (CA)
(74) Representative: Jabbusch, Matthias

(56) References cited:
- EP-A2- 1 267 399
- GB-A- 1 568 958
- US-A- 5 561 295
- US-A- 5 880 510
- US-A- 5 900 631
- US-A1- 2007 213 617
- J. F. SILIQUINI ET AL: "Two-dimensional infrared focale plane arrays based on HgCdTe photoconductive detectors", SEMICONDUCTOR SCIENCE AND TECHNOLOGY, vol. 11, 30 August 1996 (1996-08-30), pages 1906-1911, XP002731480,
- NORTON P: "HgCdTe infrared detectors", OPTO-ELECTRONICS REVIEW, WARSZAWA, PL, [Online] vol. 10, no. 3, 1 November 2002 (2002-11-01), pages 159-174, XP002599143, ISSN: 1230-3402 Retrieved from the Internet: URL:http://www.wat.edu.pl/review/optor/10( 3)159.pdf> [retrieved on 2010-09-03]

## Description

The invention relates to a method for the detection of poor rays of infrared wavelength, to a microchip that is able to detect poor infrared rays and to an apparatus working with these microchips.

In a closed body of a working machine or an electronic apparatus or a human or an animal body is to detect a source of little higher temperature than normal, when defects beginn to happen. In an electronic apparatus more warmth as usual can appear when a resistance is stressed by a to high voltage, in a working machine is in the case of a lack of oil more warmth on a place produced which breaks at first, in a human or animal body arises the temperature where the body has to defend themselves against a growing cancer.

In all these cases the beginning of a growing defect can be located when it is possible to measure only a little higher temperature in a wide distance and to locate the place of this higher temperature.

This invention gives a possibility to detect and to locate little growings cancers and others hidden places of parts of a machine with increased temperature. The invention does do it with a special microchip which is able to change photons in electrons. US5561295 discloses such a detector in which a continuous film of light detecting material is covered with a contact grid. This microchip of the invention consists of a plate of glas or an other insulating material with a rough surface on the one side. The front surface of this plate is rough by a plurality of blind holes, the ground of each of theese blind holes is covered with a thin layer of metal, in each of the blind holes are located little semiconducting crystals of a kind of material that emitts one or more electrons by each hit of an infrared light beam, the surface of this plate and the blind holes are covered with a net of very thin wires and the active part of this net of very thin wires has on its ends rails of metal to collect and transmit the electrons to a measuring instrument.

The blind holes can have the form of hemispheres, of cylindrical holes or honeycombs. Each blind hole has an inner surface of a thin layer of metal to deduct electrons from the surface or the edges of the cristals situated in the blind holes. From these metal layers and from the free edges of the cristalls the thin wires covering the surface of the glasplate deduct the electrons to the rails and to the measuring instrument (to measure voltage differences).

The cristals put in the blind holes are semiconductors made from atoms of the group VI elements such as

| | | |
|---|---|---|
| < | Cadmium selenide | Cd Se |
| < | Cadmium sulfide | Cd Ss |
| < | Cadmium telluride | Cd Te |
| < | Zinc oxide | Zn O |
| < | Zinc selenide | Zn Se |
| < | Zinc sulfide | Zn S |
| < | Zinc telluride | Zn Te |

and/or from II-VI ternary alloy semiconductos

| | | |
|---|---|---|
| < | Cadmium zinc telluride | Cd Zn Te |
| < | Mercury cadmium telluride | Hg Cd Te |
| < | Mercury zink telluride | Hg Zn Te |
| < | Mercury zink selenide | Hg Zn Se |

and/or from a I-VII semiconductor

| | | |
|---|---|---|
| < | Cuprous chloride | Cu Cl |

and/or from IV - IV semiconductors

| | | |
|---|---|---|
| < | Lead selenide | Pb Se |
| < | Lead sulfide | Pb S |
| < | Lead telluride | Pb Te |
| < | Tin sulfide | Sn S |
| < | Tin telluride | Sn Te |

and/or from IV - IV ternary semiconductors

| | | |
|---|---|---|
| < | Lead tin telluride | Pb Sn Te |
| < | Thallium tin telluride | Tl Sn Te |
| < | Thallium germanium telluride | TI Ge Te |

and/or from V - VI semiconductors

| | | |
|---|---|---|
| < | Bismuth telluride | Bi Te |
| < | II - V semiconductors | |
| < | Cadmium phosphide | Cd P |

and/or from II - V semiconductors

| | | |
|---|---|---|
| < | Cadmium phosphide | Cd P |
| < | Cadmium arsenide | Cd As |
| < | Cadmium antimonide | Cd Sb |
| < | Zinc phosphide | Zn P |
| < | Zinc arsenide | Zn As |
| < | Zinc antimonide | Zn Sb |

For this method it is usefull if the cristals of the semiconductors are sourrounded by a polymer which is grown in an acid fluid.

This polymer should be a good conductor of electrons like dendrimers and nanocarbon tube,
especially

| | |
|---|---|
| < | Poly-acethylene |
| < | Fullerenes |
| < | Melamine |
| | Poly-amidoamine |
| < | non-polar polymers |
| < | Fluoropolymers |
| < | Fluorocarbons |
| < | Polytetrafluoroethylene. |

This invention relates also to a microchip that is able to detect poor infrared rays. This microchip consists of a thin plate of glas, silicon or another hard electrical insulating material, the front surface of this glas plate is rough by a plurality of blind holes, the ground of the blind holes is covered with a thin layer of metal, in the blind holes are situated little crystals of a kind of material that that is an infrared absorber and emitts one or more electrons by each hit of an infrared light beam, the surface of this plate of glas and the blind holes is covered with a net of very thin wires and the active part of this net of very thin wires has on its ends rails to collect the electrons.

This microchip is able to detect poor infrared reys and to change whose energy in electrons. That makes it possible to find out the presence and the power of a infrared radiation also in the case that this radiation is poor.

The microchip of the invention can have a front surface of grooves in form of a regular shape like little honeycombs.

It is advantageous if the crystals of this microchip located in the blind holes are surrounded by a polymer with electrical conductivity and/or some metal coating.

Because heat can be generated in the microchip of this invention the semiconductors or the theese semiconductor carrying glas plate can be attached to or embedded in a heat deducting material.

It is advantageous for the construction of this microchip if the net of thin wires over the semiconductor cristals is so situated that they let through infrared light and catch the most of the in the semiconductors produced electrons.

To hinder a demolation of the microchip by sweat of a human body or oil of a machine or other influences it is advantageous to have a protection layer over the web of thin wires against a direct connection of the thin wires with the investigated body.

Theese microchips can be part of an apparatus for the detection of a source of poor infrared rays in a body consisting of one or more microchips und a device for the comparison the output of electrons of the microchip(s) on diverse locations of the surface of the body, par example in an apparatus with one microchip to measure the ground-radiation of the body and another microchip to measure the soft increased radiation of a defect.

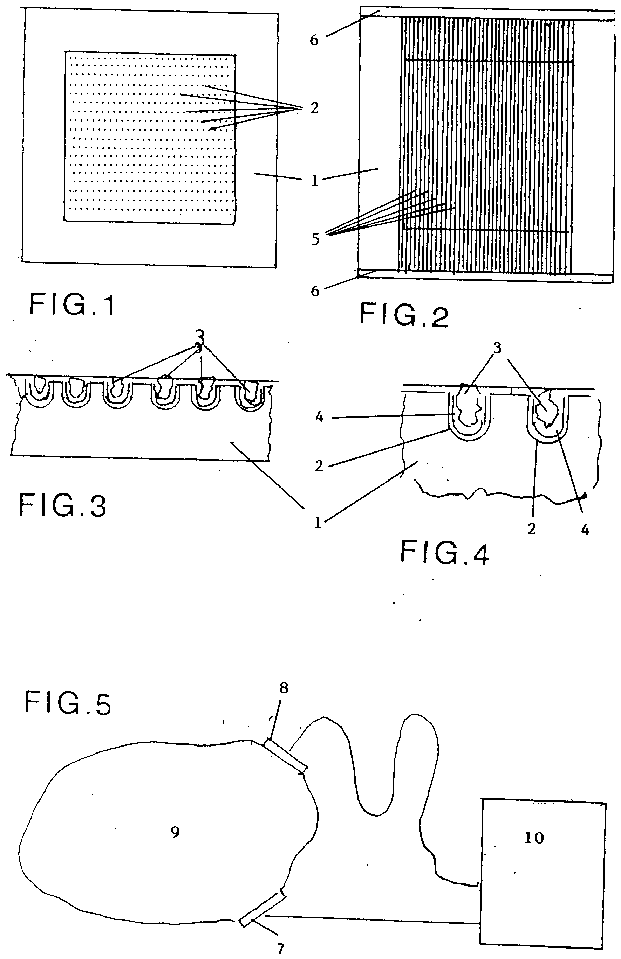

The enclosed drawing shows in
- Fig.1: a view of the surface of the microchip.
- Fig.2: a crossection through the microchip.
- Fig.3: an enlarged part of the crossection.
- Fig.4: a wiring diagramm of the apparatus using the microchips.

The microchip consists of a glas plate 1 with a rough surface on its front side, because there are many blind holes 2. In theese blind holes 2 are embedded cristals 3 of semiconductos surrounded by an acid polymer solution. The ground and the walls of the blind holes 2 are covered with a thin layer 4 of metal. Over the whole glas plate 1 with the cristals is laid a web of thin wires leading the electrons in the cristals produced electrons to the rails 5 acting as electrodes.

The apparatus 6 works with two microchips 7,8 on a body 9 to investigate. Microchip 7 is fastend on the body to ascertain the ground-radiation, microchip 8 is movable to find out a location with encreased radiation.

## Claims

1. Method for producing a microchip that is able to detect poor rays of infrared wavelength by taking a thin plate of glass (1) or another hard electrical insulating material, the front surface is rough by a plurality of blind holes, (2) by covering the blind holes with a thin layer of metal, (4) by bringing in in the holes little crystals (3) of a kind of material that emits one or more electrons by each hit of an infrared light beam, by covering the surface of the plate and the blind holes with a net of very thin wires (5) and by collecting the electrons in rails (6) at the ends of the active part of the net of very thin wires and with semiconductors as crystals of a kind of material that emits one or more electrons by each hit of an infrared light beam.

2. Method for producing a microchip according claim 1 using crystals in the blind holes as
| | | |
|---|---|---|
| < | Cadmium selenide | Cd Se |
| < | Cadmium sulfide | Cd S |
| < | Cadmium telluride | Cd Te |
| < | Zinc oxide | Zn O |
| < | Zinc selenide | Zn Se |
| < | Zinc sulfide | Zn S |
| < | Zinc telluride | Zn Te |
and/or from II - VI ternary alloy semiconductors
| | | |
|---|---|---|
| < | Cadmium zinc telluride | Cd Zn Te |
| < | Mercury cadmium telluride | Hg Cd Te |
| < | Mercury zinc telluride | Hg Zn Te |
| < | Mercury zinc selenide | Hg Zn Se |
and/or from a I - VII semiconductor
| | | |
|---|---|---|
| < | Cuprous chloride | Cu Cl |
| | | |
| | | |
and/or from IV - IV semiconductors
| | | |
|---|---|---|
| < | Lead selenide | Pb Se |
| < | Lead sulfide | Pb S |
| < | Lead telluride | Pb Te |
| < | Tin sulfide | Sn S |
| < | Tin telluride | Sn Te |
and/or from IV - IV ternary semiconductors
| | | |
|---|---|---|
| < | Lead tin telluride | Pb Sn Te |
| < | Thallium tin telluride | TI Sn Te |
| < | Thallium germanium telluride | Tl Ge Te |
and/or from V - VI semiconductors
| | | |
|---|---|---|
| < | Bismuth telluride | Bi Te |
| < | II - V semiconductors | |
| < | Cadmium phosphide | Cd P |
and/or from II - V semiconductors
| | | |
|---|---|---|
| < | Cadmium phosphide | Cd P |
| < | Cadmium arsenide | Cd As |
| < | Cadmium antimonide | Cd Sb |
| < | Zinc phosphide | Zn P |
| < | Zinc arsenide | Zn As |
| < | Zinc antimonide | Zn Sb |

3. Method according claims 1 and 2 with semiconductors surrounded by a polymer which is grown in a acid fluid.

4. Method according claim 1 to 3 using a polymer which should be a good conductor of electrons like dendrimers and nanocarbon tube, especially
| | |
|---|---|
| < | Poly-acetylene |
| < | Fullerenes |
| < | Melamine |
| < | Poly-amidoamine |
| < | non-polar polymers |
| < | Fluoropolymers |
| < | Fluorocarbons |
| < | Polytetrafluoroethylene. |

5. Microchip
that is able to detect poor infrared rays consisting of a thin plate of glass (1) or another hard electrical insulating material, the front surface of this glass plate is rough by a plurality of blind holes, (2) the ground of the blind holes is covered with a thin layer of metal, (4) in the blind holes are situated little semiconductors crystals (3) of a kind of material that that is an infrared absorber and emits one or more electrons by each hit of an infrared light beam, the surface of this plate of glass and the blind holes is covered with a net of very thin wires (5) and the active part of this net of very thin wires has on its ends rails (6) to collect the electrons.

6. Microchip according claim 5
with a front surface of grooves in form of a regular shape like little honeycombs.

7. Microchip according claim 5
with crystals situated in the blind holes surrounded by a polymer with electrical conductivity.

8. Microchip according claim 5
whose semiconductors or glass plate are attached to or embedded in a heat deducted material.

9. Microchip according claim 7
with a net of thin wires over the semiconductor crystals so situated that they let through infrared light and catch the most of the in the semiconductors produced electrons.

10. Microchip according claim 5
with a protection layer over the web of thin wires against a direct connection of the thin wires with a investigated body.

11. Apparatus for the detection of a source of poor rays of infrared wavelength in a body consisting of one or more microchips according claim 5 and device for the comparison the output of electrons of the microchip(s) on diverse locations of the surface of the body.

## Patentansprüche

1. Verfahren zur Herstellung eines Mikrochip, der in der Lage ist, schwache Strahlen von Infrarotwellenlänge zu erkennen, durch Verwenden einer dünnen Glasplatte (1) oder eines anderen harten elektrischen Isoliermaterials, dessen vordere Fläche durch eine Mehrzahl von Blindlöchern (2) aufgeraut ist, durch Bedecken der Blindlöcher mit einer dünnen Metallschicht (4), durch Einführen in die Löcher kleiner Kristalle (3) einer Art Material, das ein oder mehrere Elektronen durch jeden Treffer eines Infrarotlichtstrahls emittiert, durch Bedecken der Oberfläche der Platte und der Blindlöcher mit einem Netz aus sehr dünnen Drähten (5) und durch Auffangen der Elektronen in Schienen (6) an den Enden jedes aktive Teils des Netzes von sehr dünnen Drähten und mit Halbleitern als Kristallen irgendeiner Art Material, das ein oder mehrere Elektronen durch jeden Treffer eines Infrarotlichtstrahls emittiert.

2. Verfahren zur Herstellung eines Mikrochip nach Anspruch 1 unter Verwendung von Kristallen in den Blindlöchern als
| | | |
|---|---|---|
| < | Cadmiumselenid | Cd Se |
| < | Cadmiumsulfid | Cd S |
| < | Cadmiumtellurid | Cd Te |
| < | Zinkoxid | Zn 0 |
| < | Zinkselenid | Zn Se |
| < | Zinksulfid | Zn S |
| < | Zinktellurid | Zn Te |
und/oder ternäre Legierungs-II - VI-Halbleiter
| | | |
|---|---|---|
| < | Cadmiumzinktellurid | Cd Zn Te |
| < | Quecksilbercadmiumtellurid | Hg Cd Te |
| < | Quecksilberzinktellurid | Hg Zn Te |
| < | Quecksilberzinkselenid | Hg Zn Se |
und/oder I - VII-Halbleiter
| | | |
|---|---|---|
| < | Cuprochlorid | Cu Cl |
und/oder IV - IV-Halbleiter
| | | |
|---|---|---|
| < | Bleiselenid | Pb Se |
| < | Bleisulfid | Pb S |
| < | Bleitellurid | Pb Te |
| < | Zinnsulfid | Sn S |
| < | Zinntellurid | Sn Te |
und/oder ternäre IV - IV-Halbleiter
| | | |
|---|---|---|
| < | Bleizinntellurid | Pb Sn Te |
| < | Thalliumzinntellurid | Ti Sn Te |
| < | Thalliumgermaniumtellurid | Tl Ge Te |
und/oder V - VI-Halbleiter
| | | |
|---|---|---|
| < | Wismuttellurid | Bi Te |
| < | II - V-Halbleiter | |
| < | Cadmiumphosphid | Cd P |
und/oder II - V-Halbleiter
| | | |
|---|---|---|
| < | Cadmiumphosphid | Cd P |
| < | Cadmiumarsenid | Cd As |
| < | Cadmiumantimonid | Cd Sb |
| < | Zinkphosphid | Zn P |
| < | Zinkarsenid | Zn As |
| < | Zinkantimonid | Zn Sb |

3. Verfahren nach den Ansprüchen 1 und 2 mit Halbleitern, die von einem Polymer umgeben sind, das in einem sauren Fluid gezüchtet wird.

4. Verfahren nach Anspruch 1 bis 3, bei dem ein Polymer verwendet wird, das ein guter Leiter von Elektronen sein sollte, wie Dendrimere und Nanokohlenstoffröhren, insbesondere
| | |
|---|---|
| < | Polyacetylen |
| < | Fullerene |
| < | Melamin |
| < | Polyamidoamin |
| < | nichtpolare Polymere |
| < | Fluorpolymere |
| < | Fluorkohlenstoffe |
| < | Polytetrafluorethylen. |

5. Mikrochip, der in der Lage ist, schwache Infrarotstrahlen zu erkennen, bestehend aus einer dünnen Glasplatte (1) oder einem anderen harten elektrischen Isoliermaterial, wobei die vordere Fläche dieser Glasplatte durch eine Mehrzahl von Blindlöchern (2) aufgeraut ist, wobei der Boden der Blindlöcher mit einer dünnen Metallschicht (4) bedeckt ist, in den Blindlöchern sich kleine Halbleiterkristalle (3) einer Art Material befinden, das ein Infrarotabsorptionsmittel ist und ein oder mehrere Elektronen durch jeden Treffer eines Infrarotlichtstrahls emittiert, die Oberfläche dieser Glasplatte und die Blindlöcher mit einem Netz aus sehr dünnen Drähten (5) bedeckt sind und der aktive Teil dieses Netzes von sehr dünnen Drähten Schienen (6) an seinen Enden zum Auffangen der Elektronen aufweist.

6. Mikrochip nach Anspruch 5 mit einer vorderen Oberfläche von Vertiefungen in Form einer regelmäßigen Gestalt wie kleiner Waben.

7. Mikrochip nach Anspruch 5 mit Kristallen, die sich in den Blindlöchern befinden und von einem Polymer mit elektrischer Leitfähigkeit umgeben sind.

8. Mikrochip nach Anspruch 5 dessen Halbleiter oder Glasplatte an einem wärmeabgezogenen Material befestigt oder darin eingebettet sind.

9. Mikrochip nach Anspruch 7 mit einem Netz dünner Drähte über den Halbleiterkristallen, die so positioniert sind, dass sie Infrarotlicht hindurchlassen und den Hauptteil der in den Halbleitern erzeugten Elektronen auffangen.

10. Mikrochip nach Anspruch 5 mit einer Schutzschicht über dem Netzwerk dünner Drähte gegen eine direkte Verbindung der dünnen Drähte mit einem untersuchten Körper.

11. Apparat zur Erkennung einer Quelle schlechter Strahlen einer Infrarotwellenlänge in einem Körper, bestehend aus einem oder mehreren Mikrochip nach Anspruch 5 und Vorrichtung zum Vergleichen der Abgabe von Elektronen des/der Mikrochip an verschiedenen Stellen der Oberfläche des Körpers.

## Revendications

1. Procédé de production d'une micropuce qui est capable de détecter les faibles rayons de longueur d'onde infrarouge en utilisant une plaque mince de verre (1) ou un autre matériau isolant électrique dur, la surface avant est rendue rugueuse par une pluralité de trous borgnes (2), en recouvrant les trous borgnes avec une couche mince de métal (4), en amenant dans les trous de petits cristaux (3) d'un type de matériau qui émet un ou plusieurs électrons à chaque atteinte d'un faisceau de lumière infrarouge, en recouvrant la surface de la plaque et les trous borgnes d'un réseau de fils très minces (5) et en recueillant les électrons dans des rails (6) aux extrémités de la partie active du réseau de fils très minces et avec des semi-conducteurs en tant que cristaux d'un type de matériau qui émet un ou plusieurs électrons à chaque atteinte d'un faisceau de lumière infrarouge.

2. Procédé de production d'une micropuce selon la revendication 1 utilisant des cristaux dans les trous borgnes sous forme de
| | | |
|---|---|---|
| < | séléniure de cadmium | Cd Se |
| < | sulfure de cadmium | Cd S |
| < | tellurure de cadmium | Ce Te |
| < | oxyde de zinc | Zn O |
| < | séléniure de zinc | Zn Se |
| < | sulfure de zinc | Zn S |
| < | tellurure de zinc | Zn Te |
et/ou de semi-conducteurs d'alliages ternaires II - VI
| | | |
|---|---|---|
| < | tellurure de zinc-cadmium | Cd Zn Te |
| < | tellurure de mercure-cadmium | Hg Cd Te |
| < | tellurure de mercure-zinc | Hg Zn Te |
| < | séléniure de mercure-zinc | Hg Zn Se |
et/ou de semi-conducteurs I - VII
| | | |
|---|---|---|
| < | chlorure de cuivre | Cu Cl |
et/ou de semi-conducteurs IV - IV
| | | |
|---|---|---|
| < | séléniure de plomb | Pb Se |
| < | sulfure de plomb | Pb S |
| < | tellurure de plomb | Pb Te |
| < | sulfure d'étain | Sn S |
| < | tellurure d'étain | Sn Te |
et/ou de semi-conducteurs d'alliages ternaires IV - IV
| | | |
|---|---|---|
| < | tellurure de plomb-étain | Pb Sn Te |
| < | tellurure de thallium-étain | Tl Sn Te |
| < | tellurure de thallium-germanium | Tl Ge Te |
et/ou de semi-conducteurs V - VI
| | | |
|---|---|---|
| < | tellurure de bismuth | Bi Te |
| < | semi-conducteurs II - V | |
| < | phosphure de cadmium | Cd P |
et/ou de semi-conducteurs II - V
| | | |
|---|---|---|
| < | phosphure de cadmium | Cd P |
| < | arséniure de cadmium | Cd As |
| < | antimoine de cadmium | Cd Sb |
| < | phosphure de zinc | Zn P |
| < | arséniure de zinc | Zn As |
| < | antimoine de zinc | Zn Sb. |

3. Procédé selon les revendications 1 et 2 avec des semi-conducteurs entourés par un polymère qui est développé dans un fluide acide.

4. Procédé selon les revendications 1 à 3 utilisant un polymère qui doit être un bon conducteur pour les électrons tels que les dendrimères et un nanotube de carbone, en particulier
| | |
|---|---|
| < | un polyacétylène |
| < | les fullerènes |
| < | une mélamine |
| < | une polyamidoamine |
| < | des polymères non polaires |
| < | des polymères fluorés |
| < | des hydrocarburesfluorés |
| < | un polytétrafluoroéthylène. |

5. Micropuce qui est capable de détecter les faibles rayons de longueur d'onde infrarouge en utilisant une plaque mince de verre (1) ou un autre matériau isolant électrique dur, la surface avant est rendue rugueuse par une pluralité de trous borgnes (2), la zone des trous borgnes est recouverte d'une couche mince de métal (4), dans les trous borgnes sont situés de petits cristaux de semi-conducteurs (3) d'un type de matériau qui est un absorbeur d'infrarouge et émet un ou plus électrons à chaque atteinte d'un faisceau de lumière infrarouge, la surface de cette plaque de verre et des trous borgnes est recouverte d'un réseau de fils très minces (5) et la partie réactive de ce réseau de fils très minces a sur ses extrémités des rails qui recueillent les électrons.

6. Micropuce selon la revendication 5 ayant une surface avant constituée de rainures sous la forme d'une forme régulière telle que de petits nids d'abeilles.

7. Micropuce selon la revendication 5 ayant des cristaux situés dans les trous borgnes entourés par un polymère ayant une conductivité électrique.

8. Micropuce selon la revendication 5 dont les semi-conducteurs ou la plaque de verre sont attachés à ou ancrés dans un matériau déduit par la chaleur.

9. Micropuce selon la revendication 7 ayant un réseau de fils minces sur les cristaux de semi-conducteurs placés de telle sorte qu'ils laissent passer la lumière infrarouge et attrapent la plupart des électrons produits par les semi-conducteurs.

10. Micropuce selon la revendication 5 ayant une couche de protection sur le réseau de fils minces empêchant une connexion directe des fils minces avec un corps étudié.

11. Appareil de détection d'une source de faibles rayons de longueur d'onde infrarouge dans un corps constitué par une ou plusieurs micropuces selon la revendication 5 et un dispositif permettant la comparaison de la sortie des électrons de la ou des micropuces en divers endroits de la surface du corps.
